# EUROPEAN PATENT APPLICATION

(11) **EP 4 553 526 A1**
(43) Date of publication of application: **14.05.2025**
(21) Application number: 24208907.6
(22) Date of filing: 25.10.2024
(51) Int. Cl.: G01R 31/68, G01R 31/69

(54) **REMOTE MONITORING SYSTEM AND METHOD FOR AN ELECTRICAL CONNECTOR**

(30) Priority: 10.11.2023 CN 202311499005
(71) Applicant: Harting International Innovation AG, 2504 Biel (CH)
(72) Inventor: Huang, Xu Yan, Guangdong, 518048 (CN)

(57) **Abstract**

The present application discloses a remote monitoring system (10) and method for an electrical connector (20). The remote monitoring system (10) comprises: a detection module (102), connected to the electrical connector (20), and inputting a detection signal to the electrical connector (20); a processing module (104), connected to the electrical connector (20), and the processing module (104) being configured to receive a response signal of the electrical connector (20) to the detection signal, the processing module (104) being configured to derive connectivity status data from the response signal, wherein the connectivity status data indicates a connectivity status of the electrical connector (20); a transmission module (106), connected to the processing module (104), and the transmission module (106) being configured to receive the connectivity status data and transmit the connectivity status data to a remote management module (108); and the remote management module (108), receiving the connectivity status data transmitted by the transmission module (106), and the remote management module (108) being configured to analyze the connectivity status data to generate remote monitoring information for the electrical connector (20).

## Description

### Technical Field

The present invention relates to the field of electrical connectivity devices, and in particular, to a remote monitoring system and method for an electrical connector.

### Background Art

External electrical connectivity between electrical devices generally needs to be completed by means of a connector, and electric energy and signals are transferred between the devices. The quality and reliability of the connector directly affect normal operation of the whole electrical apparatus, and thus the connector is a very critical component. The number of connectors in a ship product is very large, and if a certain connector has a fault such as disconnection, short circuit, transient interruption, poor insulation, poor contact, wrong wiring, etc., an inestimable effect will be generated on the whole electrical apparatus, and therefore it is necessary to detect the electrical performance of the connectors.

In the past decades, the traditional ship/boat industry has stepped to an unmanned surface vehicle (USV) stage. The working mode of USV had changed from on-board operation to remote control by operators on shore. The USV worked like a self-autonomous robot. Under new operation and control conditions, the unmanned surface vehicle's electrical connectivity requirements would also have the following new requirements accordingly:
1) firstly, since there is no staff on the unmanned surface vehicle to inspect and process on-site problems, the unmanned surface vehicle requires more stringent self-inspection and diagnostics electrical system on board;
2) secondly, a smart interconnection system would become necessary for USV's remote controller to guarantee USV's healthy work at sea; connectivity information related to the USV's operation, safety and emergency processing needs to be transmitted to the USV's upper-level remote control system; and in this way, operators on shore could monitor a real-time working status of connectors on board, to make sure that the USV's connectivity system was under healthy status; and
3) thirdly, to keep USV's safe operation at sea, quick connectivity problem troubleshoot would also be highly demanded; and traditional method to inspect and monitor the connector was through manual on-site checking.

There were no real-time connectivity status data transferred to the USV's upper-level remote controller yet. Therefore, when the USV was working at sea, the operators on shore had no direct way to accurately estimate a USV electrical system's connectivity status. Especially, when the USV had emergencies at sea, it would be quite difficult to troubleshoot and fix the connectivity problem.

Without real-time connectivity status data, the operating safety and electrical system reliability of the USV cannot be real-time monitored. For example, the USV's operators on shore didn't have a straightforward way to estimate a real working status of the connectors when the USV was working at sea. Therefore, when there were emergencies occurred, it would be quite difficult to troubleshoot or fix the USV's connectivity problem. The USV's operation may be out of control, and damaging or even devastating accidents may happen.

The present invention aims to provide a smart connectivity system and method for USV's next generation electrical architecture, the system and method significantly improving the USV's electrical reliability and further guaranteeing that the USV executes complex independent tasks at sea.

### Summary

In view of this, the present invention proposes a remote monitoring system and method for an electrical connector, hereinafter abbreviated as connector. The system comprises two major technical features, 1) a high frequency injection method to estimate the connector's contact resistance value is proposed to estimate the connector's real-time healthy status; and 2) a connectivity service software platform (API) which could manage information of connectivity terminals, monitor a real-time connectivity status, and troubleshoot connectivity problems is proposed for a USV's electrical system. A novel smart connectivity service system described in this invention proposes a system level integrated digital connectivity management solution for an unmanned surface vehicle. System configuration of the present invention can be divided into three layers. The bottom layer is a smart connector with a connectivity status data collection unit. The middle layer is a data transmission channel used to transmit connectivity data from the smart connector to the USV's smart controller. The top layer is a smart connectivity management software (API) which is embedded into the USV's smart software platform.

According to embodiments of the present invention, provided is a remote monitoring system for a connector, the remote monitoring system comprising: a detection module, connected to the connector, and the detection module being configured to input a detection signal to the connector; a processing module, connected to the connector, and the processing module being configured to receive a response signal of the connector to the detection signal, the processing module being configured to derive connectivity status data from the response signal, wherein the connectivity status data indicates a connectivity status of the connector; a transmission module, connected to the processing module, and the transmission module being configured to receive the connectivity status data and transmit the connectivity status data to a remote management module; and the remote management module, receiving the connectivity status data transmitted by the transmission module, and the remote management module being configured to analyze the connectivity status data to generate remote monitoring information for the connector.

The processing module can comprise a comparison unit, the comparison unit can be configured to compare the response signal with a preset threshold and to generate a warning signal when the response signal is greater than the threshold.

The detection module can comprise a high frequency injection circuit unit, the high frequency injection circuit unit can generate a high frequency detection signal as the detection signal.

The processing module can be configured to receive a voltage response signal or a current response signal of the connector with respect to the high frequency detection signal, and to derive a contact impedance value of the connector on the basis of the voltage response signal or the current response signal, and to take the derived contact impedance value as the connectivity status data.

The transmission module can receive the connectivity status data and the warning signal, and can transmit the connectivity status data and the warning signal to the remote management module.

The remote management module can analyze the connectivity status data to generate a graphical user interface including the analyzed results and can provide the graphical user interface to the operator to view the analyzed results, the graphical user interface can further comprise a graphical display for indicating a connectivity status of the connector in a real-time manner or at predetermined time intervals.

The remote management module can analyze the connectivity status data and the warning signal to generate a graphical user interface, the graphical user interface can comprise the warning signal and a graphical display for indicating a connectivity status of the connector in a real-time manner or at predetermined time intervals.

The connectivity status data can contain an identifier of the connector, the remote management module can store the identifier of the connector and the connectivity status data in an associated manner, and the identifier of the connector can be obtained by scanning a graphic symbol on the surface of the connector.

The remote management module can be installed in a user terminal, and the remote management module can perform data communication with the transmission module in a wired or wireless manner.

The remote management module can comprise a fault diagnosis unit, the fault diagnosis unit can analyze the connectivity status data to generate fault diagnosis information.

According to other embodiments of the present invention, provided is a remote monitoring method for a connector, the remote monitoring method comprising: a detection step of inputting a detection signal to the connector; a processing step of receiving a response signal of the connector to the detection signal, and deriving connectivity status data from the response signal, wherein the connectivity status data indicates a connectivity status of the connector; a transmission step of receiving the connectivity status data and transmitting the connectivity status data to a remote management module; and a remote management step of receiving the connectivity status data and analyzing the connectivity status data to generate remote monitoring information for the connector.

The processing step can comprise: comparing the response signal with a preset threshold, and generating a warning signal when the response signal is greater than the threshold.

The detection step can comprise: generating a high frequency detection signal as the detection signal.

In the processing step, a voltage response signal or a current response signal of the connector with respect to the high frequency detection signal can be received, and a contact impedance value of the connector can be derived on the basis of the voltage response signal or the current response signal, and the derived contact impedance value can be taken as the connectivity status data.

In the transmission step, the connectivity status data and the warning signal can be received, and the connectivity status data and the warning signal can be transmitted to the remote management module.

In the remote management step, the connectivity status data can be analyzed to generate a graphical user interface including the analyzed results and the graphical user interface can be provided to the operator to view the analyzed results, the graphical user interface further comprising a graphical display for indicating a connectivity status of the connector in a real-time manner or at predetermined time intervals.

In the remote management step, the connectivity status data and the warning signal can be analyzed to generate a graphical user interface, the graphical user interface can comprise the warning signal and a graphical display for indicating a real-time connectivity status of the connector.

The connectivity status data can contain an identifier of the connector, in the remote management step, the identifier of the connector and the connectivity status data can be stored in an associated manner, and the identifier of the connector can be obtained by scanning a graphic symbol on the surface of the connector.

In the remote management step, the connectivity status data can be analyzed to generate fault diagnosis information.

The method and corresponding steps as set forth herein may be implemented, at least in part, on a computer or distributed computer system and may therefore be considered a computer-implemented method.

According to embodiments, the invention may comprise a computer program product comprising instructions which, when the program is executed by a computer or distributed computer system, cause the computer or system to perform steps of the method as previously described herein.

According to embodiments, the invention may comprise a computer-readable storage medium comprising instructions which, when executed by a computer or distributed computer system, cause the computer or system to perform steps of the method as previously described herein.

Based on the present invention, there are three major advantages:
1) The reliability of the USV's connectivity system can be further enhanced and hence the total electrical system would be benefited based on additional digital connectivity status data.
2) The self-inspection and diagnostics capability of the connectivity system can be established; and the connectivity inspection efficiency can be speeded up and problems can be predicted in advance.
3) The operators on shore can monitor the real-time working status of the connectors; and in case there are emergencies, the connectivity problem can be troubleshooted and fixed in time to avoid accidents happened.

### Brief Description of the Drawings

Hereinafter, preferred embodiments of the present invention will be described in detail with reference to the accompanying drawings, such that a person of ordinary skill in the art could understand the described and other features and advantages of the present invention more clearly, in which:
Fig. 1 shows a schematic diagram of main components of a remote monitoring system for a connector according to an embodiment of the present invention.
Fig. 2 shows a schematic diagram of a circuit adopting a high frequency injection method according to an embodiment of the present invention.
Fig. 3 shows a schematic diagram of a graphical user interface presented by remote management according to an embodiment of the present invention.
Fig. 4 shows a flowchart of a remote monitoring method for a connector according to an embodiment of the present invention.

### Detailed Description of the Embodiments

To make the objectives, technical solutions, and advantages of the present invention clearer, hereinafter, the present invention is further described in detail by taking embodiments as examples.

It is to be illustrated that embodiments and the features in the embodiments of the present application can be combined with one another without conflicts. Hereinafter, the present invention will be described in detail with reference to the drawings in combination with embodiments.

It is to be noted that unless otherwise indicated, all technical and scientific terms used in the present application have the same meanings as those commonly understood by a person of ordinary skill in the art to which the present application belongs.

In the present invention, unless specified to the contrary, directional terms such as "upper, lower, top, and bottom" are generally used regarding the directions shown in the figures, or for the components themselves in vertical, perpendicular, or gravity directions; likewise, for ease of understanding and description, "inner and outer" refers to the inner and outer relative to the outline of each component itself, but the described directional terms are not used to limit the present invention.

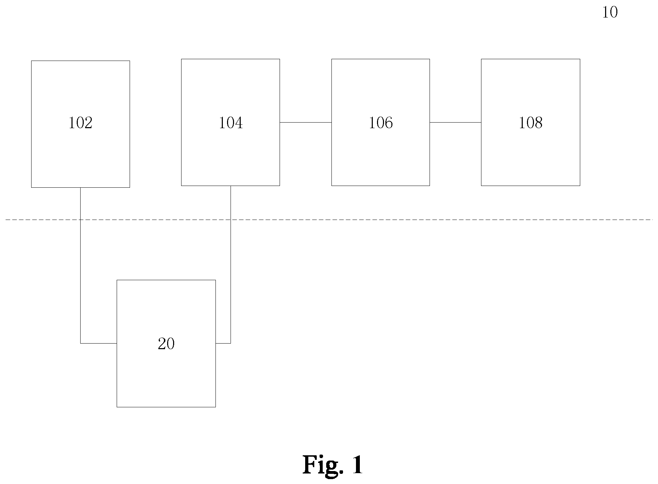

Fig. 1 shows a schematic diagram of main components of a remote monitoring system for a connector according to an embodiment of the present invention.

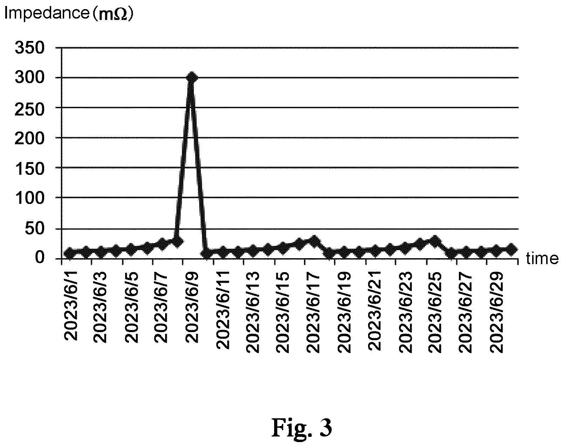

As shown in Fig. 1, the remote monitoring system 10 comprises: 1) a detection module 102, connected to the connector 20, and the detection module 102 being configured to input a detection signal to the connector 20; for example, the detection module 102 may comprise a high frequency injection circuit unit, the high frequency injection circuit unit generating a high frequency detection signal as the detection signal; specifically, for selecting a characteristic frequency of a high frequency voltage signal generated by the high frequency injection circuit unit, various limiting factors such as a line length and a detection apparatus may be considered, in particular, the frequency of the high frequency voltage signal should differ significantly from an operating frequency of the connector 20; the frequency of the high frequency detection signal is far higher than the frequency of a drive voltage of the connector 20, and the two do not interfere with each other; the high frequency detection signal is used for fault online detection of the connector 20, and the low frequency drive voltage is used for controlling normal operation of the connector 20; the larger the amplitude value of the high frequency detection signal is selected, the more beneficial it is for detection, but requirements such as the withstand capability of an electronic device itself, the range of the detection apparatus, the withstand current impact of the system, etc. should also be taken into consideration; 2) a processing module 104, connected to connector 20, an the processing module 104 being configured to receive a response signal of the connector 20 to the detection signal, the processing module 104 deriving connectivity status data from the response signal; wherein the connectivity status data indicates a connectivity status of the connector 20, the connectivity status data can further comprise an identifier of the connector 20, and the identifier of the connector 20 can be obtained by scanning a graphic symbol (for example, a two-dimensional code or a bar code) on the surface of the connector 20; for example, the processing module 104 receives a voltage response signal or a current response signal of the connector 20 with respect to the high frequency detection signal, and derives a contact impedance value of the connector 20 on the basis of the voltage response signal or the current response signal, and takes the derived contact impedance value as the connectivity status data; in addition, the processing module 104 may comprise a comparison unit, the comparison unit comparing the response signal with a preset threshold and generating a warning signal when the response signal is greater than the threshold; for example, the comparison unit compares the voltage response signal with a preset threshold voltage, and generates a warning signal when the voltage response signal is greater than the threshold voltage; or the comparison unit compares the current response signal with a preset threshold current, and generates a warning signal when the current response signal is greater than the threshold current. 3) a transmission module 106, connected to the processing module 104, and the transmission module 104 receiving the connectivity status data and/or the warning signal, and transmitting the connectivity status data and/or the warning signal to a remote management module 108 in a wired or wireless manner; and 4) the remote management module 108, receiving the connectivity status data and/or the warning signal transmitted by the transmission module 106, and storing the identifier of the connector 20 and the connectivity status data in an associated manner, and the remote management module 108 analyzing the connectivity status data and/or the warning signal to generate remote monitoring information for the connector 20; for example, the remote management module 108 analyzes the connectivity status data and the warning signal, to generate a graphical user interface, the graphical user interface comprising a warning signal and a graphical display for indicating a real-time connectivity status of the connector 20 (for example, the graph of impedance values vs. time as shown in Fig. 3). In addition, the remote management module 108 may comprise a fault diagnosis unit, the fault diagnosis unit analyzing the connectivity status data and/or the warning signal to generate fault diagnosis information, and troubleshooting guidance can also be provided regarding the fault diagnosis information.

In the remote monitoring system 10 as shown in Fig. 1, the detection module 102, the processing module 104, and the transmission module 106 may be installed in the unmanned surface vehicle together with the connector 20; and the remote management module 108 can be installed in a user terminal (for example, smart apparatuses such as a handheld smart device or a computer), and the user terminal can be operated by a user on shore. In the process of remote monitoring of the connector 20, the user can operate the user terminal to scan a graphic symbol (e.g. a two-dimensional code or a bar code) on the surface of the connector 20 to obtain the identifier of the connector 20, and can define the name of the connector 20 through a user input apparatus and set various parameters of the connector 20 (e.g. monitoring frequency, threshold, etc. regarding the connector 20). Next, the remote management module 108 receives the connectivity status data and/or warning signal transmitted by the transmission module 106 in a wired or wireless manner, and stores the identifier of the connector 20 and the received corresponding connectivity status data and/or warning signal in an associated manner, and analyzes the connectivity status data and/or the warning signal to generate remote monitoring information for the connector 20. For example, the remote management module 108 analyzes the connectivity status data and the warning signal to generate a graphical user interface containing various monitoring information.

Additionally, although in Fig. 1, the remote monitoring system 10 and the connector 20 are shown as two separate components, the remote monitoring system 10 may be integrated with the connector 20 as needed. For example, the detection module 102, the processing module 104, the transmission module 106 of the remote monitoring system 10 may be integrated as one integral component with the connector 20.

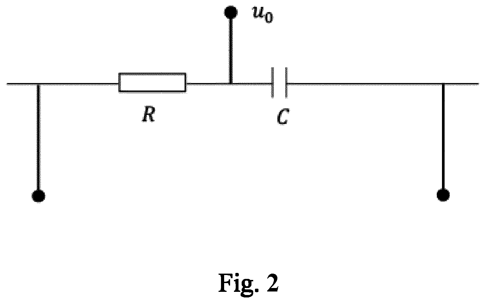

Fig. 2 shows a schematic diagram of a circuit adopting a high frequency injection method according to an embodiment of the present invention. As shown in Fig. 2, the high frequency injection circuit unit of the detection module generates a high frequency detection signal u₀ as the detection signal, and derives a contact impedance value R of the connector according to a formula uᵢ=Asinωt; where in Fig. 2, C represents a capacitor, and R represents a contact impedance of the connector.

In addition, in addition to the high frequency injection method, a constant-current source manner may also be used to derive the contact impedance value of the connector.

Fig. 3 shows a schematic diagram of a graphical user interface presented by the remote management module 108 according to an embodiment of the present invention. As shown in Fig. 3, the graphical user interface presented by the remote management module 108 comprises a graph of contact impedance value of the connector 20 vs. date. The contact impedance values as shown in Fig. 3 are real-time contact impedance values of the connector 20 received from June 1, 2023 to June 29, 2023. As shown in the graphical user interface, the real-time contact impedance value of the connector 20 received on June 9, 2023 is 300 mΩ, which is highlighted as a warning signal. In addition, the fault diagnosis unit of the remote management module 108 can analyze the connectivity status data and/or the warning signal to generate fault diagnosis information, and can provide troubleshooting guidance, and can provide the fault diagnosis information and the troubleshooting guidance to the user via, for example, the graphical user interface. In Fig. 3, for clarity of description, real-time contact impedance values of only one connector 20 are shown; however, it will be understood that the real-time contact impedance values of a plurality of connectors can be displayed respectively, for example, by different colors or different curve shapes. In addition, the graphical user interface may also display an overlay window or a mini-window, the overlay window or the mini-window may display labels of the plurality of connectors, and the user can switch to display real-time contact impedance values of the plurality of connectors by selecting the labels of the connectors in the overlay window or the mini-window. In addition, in order to save power consumption and be more efficient, a contact impedance value of the connector may be displayed at a predetermined time interval. For example, the operator may set the predetermined time interval to weekly, monthly, as needed.

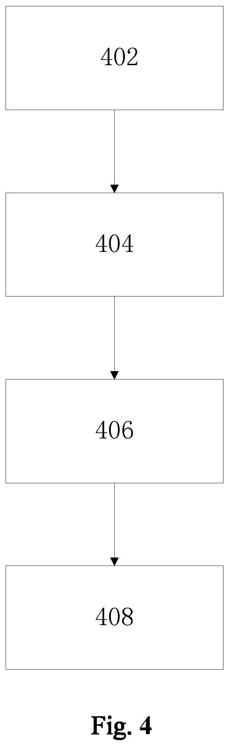

Fig. 4 shows a flowchart of a remote monitoring method for a connector according to an embodiment of the present invention. As shown in Fig. 4, the remote monitoring method for a connector comprises: a detection step 402 of inputting a detection signal to the connector; a processing step 404 of receiving a response signal of the connector to the detection signal, and deriving connectivity status data from the response signal, wherein the connectivity status data indicates a connectivity status of the connector; a transmission step 406 of receiving the connectivity status data and transmitting the connectivity status data to a remote management module; and a remote management step 408 of receiving the connectivity status data and analyzing the connectivity status data to generate remote monitoring information for the connector.

The processing step 404 may comprise: comparing the response signal with a preset threshold, and generating a warning signal when the response signal is greater than the threshold.

The detection step 402 may comprise: generating a high frequency detection signal as the detection signal.

In the processing step 404, a voltage response signal or a current response signal of the connector with respect to the high frequency detection signal is received, and a contact impedance value of the connector is derived on the basis of the voltage response signal or the current response signal, and the derived contact impedance value is taken as the connectivity status data.

In the transmission step 406, the connectivity status data and the warning signal are received, and the connectivity status data and the warning signal are transmitted to the remote management module.

In the remote management step 408, the connectivity status data is analyzed to generate a graphical user interface including the analyzed results and the graphical user interface is provided to the operator to view the analyzed results, the graphical user interface comprising a graphical display for indicating a real-time connectivity status of the connector.

In the remote management step 408, the connectivity status data and the warning signal are analyzed to generate a graphical user interface, the graphical user interface comprising the warning signal and a graphical display for indicating a real-time connectivity status of the connector.

The connectivity status data contains an identifier of the connector, in the remote management step, the identifier of the connector and the connectivity status data are stored in an associated manner, and the identifier of the connector can be obtained by scanning a graphic symbol on the surface of the connector.

In the remote management step 408, the connectivity status data is analyzed to generate fault diagnosis information.

The present invention can be directly used for control of unmanned surface vehicles. Furthermore, the present invention can also be extended to more unmanned scenarios, such as the maintenance of wind farm, solar farm, and lighting factory. The present invention provides a system-level total solution for USV's connectivity system management.

The remote monitoring system for a connector can be integrated with conventional connectors to form smart connectors. In addition, both the new smart connectors and the service software platform can be offered to a customer, so as to achieve the following technical effects: 1) a system-level smart connectivity solution including the smart connectors and a software service platform for the unmanned surface vehicle (USV) is offered to the customer; 2) in the present invention, the connector's real-time healthy working condition could be estimated through measuring the connector's voltage/current value, and failure alert can also be detected and predicted in advance; and 3) based on the present invention, USV operators on shore can quickly troubleshoot and inspect the connectivity problems to guarantee USV's safe operation at sea; and in addition, the present invention can also be extended to the maintenance of wind farm, solar farm and lighting factory, etc.

The described content merely relates to preferred embodiments of the present invention, and is not intended to limit the present invention. Any modifications, equivalent replacements, improvements, etc. made within the spirit and principle of the present invention shall all fall within the scope of protection of the present invention.

## Claims

1. A remote monitoring system (10) for an electrical connector (20), wherein the remote monitoring system (10) comprises:
a detection module (102), connected to the electrical connector (20), and the detection module (102) being configured to input a detection signal to the electrical connector (20);
a processing module (104), connected to the electrical connector (20), and the processing module (104) being configured to receive a response signal of the electrical connector (20) to the detection signal, the processing module (104) being configured to derive connectivity status data from the response signal, wherein the connectivity status data indicates a connectivity status of the electrical connector (20);
a transmission module (106), connected to the processing module (104), and the transmission module (106) being configured to receive the connectivity status data and transmit the connectivity status data to a remote management module (108); and
the remote management module (108), receiving the connectivity status data transmitted by the transmission module (106), and the remote management module (108) being configured to analyze the connectivity status data to generate remote monitoring information of the electrical connector (20).

2. The remote monitoring system (10) according to claim 1, wherein the processing module (104) comprises a comparison unit, the comparison unit being configured to compare the response signal with a preset threshold and to generate a warning signal when the response signal is greater than the threshold.

3. The remote monitoring system (10) according to claim 1 or 2, wherein the detection module (102) comprises a high frequency injection circuit unit, the high frequency injection circuit unit generating a high frequency detection signal as the detection signal.

4. The remote monitoring system (10) according to claim 3, wherein the processing module (104) is configured to receive a voltage response signal or a current response signal of the electrical connector (20) with respect to the high frequency detection signal, and to derive a contact impedance value of the electrical connector (20) on the basis of the voltage response signal or the current response signal, and to take the derived contact impedance value as the connectivity status data.

5. The remote monitoring system (10) according to claim 2, wherein the transmission module (106) receives the connectivity status data and the warning signal, and transmits the connectivity status data and the warning signal to the remote management module (108).

6. The remote monitoring system (10) according to claim 1, wherein the remote management module (108) analyzes the connectivity status data to generate a graphical user interface including analyzed results and provide the graphical user interface to an operator to view the analyzed results, the graphical user interface further comprising a graphical display for indicating a connectivity status of the electrical connector (20) in a real-time manner or at predetermined time intervals.

7. The remote monitoring system (10) according to claim 5, wherein the remote management module (108) analyzes the connectivity status data and the warning signal to generate a graphical user interface, the graphical user interface comprising the warning signal and a graphical display for indicating a connectivity status of the electrical connector (20) in a real-time manner or at predetermined time intervals.

8. The remote monitoring system (10) according to claim 1 or 2, wherein the connectivity status data contains an identifier of the electrical connector (20), the remote management module (108) stores the identifier of the electrical connector (20) and the connectivity status data in an associated manner, and the identifier of the electrical connector (20) can be obtained by scanning a graphic symbol on the surface of the electrical connector (20).

9. The remote monitoring system (10) according to claim 1 or 2, wherein the remote management module (108) is installed in a user terminal, and the remote management module (108) performs data communication with the transmission module (106) in a wired or wireless manner.

10. The remote monitoring system (10) according to claim 1 or 2, wherein the remote management module (108) comprises a fault diagnosis unit, the fault diagnosis unit analyzing the connectivity status data to generate fault diagnosis information.

11. A remote monitoring method for an electrical connector (20), wherein the remote monitoring method comprises:
a detection step (402) of inputting a detection signal to the electrical connector (20);
a processing step (404) of receiving a response signal of the electrical connector (20) to the detection signal, and deriving connectivity status data from the response signal, wherein the connectivity status data indicates a connectivity status of the electrical connector (20);
a transmission step (406) of receiving the connectivity status data and transmitting the connectivity status data to a remote management module (108); and
a remote management step (408) of receiving the connectivity status data and analyzing the connectivity status data to generate remote monitoring information for the electrical connector (20).

12. The remote monitoring method according to claim 11, wherein the processing step (404) comprises: comparing the response signal with a preset threshold, and generating a warning signal when the response signal is greater than the threshold, preferably the detection step (402) comprises: generating a high frequency detection signal as the detection signal, and optionally in the transmission step (406), the connectivity status data and the warning signal are received, and the connectivity status data and the warning signal are transmitted to the remote management module (108).

13. The remote monitoring method according to claim 11 or 12, wherein in the processing step (404), a voltage response signal or a current response signal of the electrical connector (20) with respect to the high frequency detection signal is received, and a contact impedance value of the electrical connector (20) is derived on the basis of the voltage response signal or the current response signal, and the derived contact impedance value is taken as the connectivity status data.

14. The remote monitoring method according to claim 11, wherein in the remote management step (408), the connectivity status data is analyzed to generate a graphical user interface including analyzed results and the graphical user interface is provided to an operator to view the analyzed results,, the graphical user interface further comprising a graphical display for indicating a connectivity status of the electrical connector (20) in a real-time manner or at predetermined time intervals.

15. The remote monitoring method according to claim 12, wherein in the remote management step (408), the connectivity status data and the warning signal are analyzed to generate a graphical user interface, the graphical user interface comprising the warning signal and a graphical display for indicating a connectivity status of the electrical connector (20) in a real-time manner or at predetermined time intervals.
